# EUROPEAN PATENT APPLICATION

(11) **EP 3 166 225 A1**
(43) Date of publication of application: **10.05.2017**
(21) Application number: 16197736.8
(22) Date of filing: 08.11.2016
(51) Int. Cl.: H03H 9/72, H04B 1/52, H03H 7/46, H03H 9/70

(54) **DUPLEXER DEVICE AND SUBSTRATE FOR MOUNTING DUPLEXER**

(30) Priority: 09.11.2015 KR 20150156382
(71) Applicant: Handy International Co., Ltd., Tokyo 103-0001 (JP)
(72) Inventor: Tajima, Motoyuki, Kawasaki-city, Kanagawa (JP); Sato, Takahiro, Kawasaki-city, Kanagawa (JP)
(74) Representative: Caspary, Karsten

(57) **Abstract**

Disclosed herein is a duplexer device having a plurality of duplexers mounted on a substrate for mounting a duplexer, for achieving an excellent isolation characteristic. The duplexer device includes a substrate for mounting a duplexer, the substrate having a rectangular shape including a first side, a second side neighboring the first side and connected to the first side, a third side facing the second side and neighboring the first side, and a fourth side connected to the second and the third sides and facing the first side, and a plurality of pads being formed on a surface of the substrate; a first duplexer configured to be mounted on the substrate for mounting a duplexer and to include a first antenna terminal, a first transmission terminal and a first reception terminal; and a second duplexer configured to be mounted on the substrate for mounting a duplexer and to include a second antenna terminal, a second transmission terminal and a second reception terminal. The first antenna terminal and the second antenna terminal are electrically connected to pads for an antenna, respectively, which belong to the plurality of pads and are disposed along the first side. The first reception terminal and the second reception terminal are electrically connected to pads for reception, respectively, which belong to the plurality of pads and are disposed along the second side. The first transmission terminal and the second transmission terminal are electrically connected to pads for transmission, respectively, which belong to the plurality of pads and are disposed along the third side.

## Description

### BACKGROUND OF THE INVENTION

The present invention relates to a duplexer device and a substrate for mounting a duplexer.

A duplexer including a SAW (SAW) device is mounted on a communication device, such as a handheld terminal, in order to electrically separate the transmission path and reception path of an antenna.

Recently, a technology in which a plurality of duplexers having different transmission and reception bands is mounted on a communication device in order to handle a plurality of bands having different frequency bands and a duplexer according to a corresponding band is switched by a switch comes on the stage.

Japanese Patent Application Publication No. 2003-517239, herein referred to as Patent Document 1, discloses a module including a dual duplexer having two SAW filters. The disclosed module includes the input side and the output side, and has an antenna and a switch disposed on the input side and a reception-side switch and a transmission-side switch disposed on the output side.

### SUMMARY OF THE INVENTION

If a dual duplexer is modulated, it is considered that an isolation characteristic between the two duplexers is inevitably deteriorated. Accordingly, there is a possibility that an excellent isolation characteristic may not be obtained in the module of Patent Document 1.

However, Patent Document 1 does not mention any problem in the configured module. In particular, Patent Document 1 does not take into consideration a problem if the antenna (ANT) terminal, reception (Rx) terminal and transmission (Tx) terminal of the two SAW filters are disposed.

In accordance with the research and experiments of the inventors, in a modulated dual duplexer device, it has been determined that an isolation characteristic is greatly changed depending on the deployment of the ANT terminal, Tx terminal and Rx terminal of a SAW filter that forms each duplexer.

An object of the present invention is to provide a duplexer device capable of easily obtaining an excellent isolation characteristic and a substrate for mounting a duplexer.

A duplexer device according to an aspect of the present invention includes a substrate for mounting a duplexer, the substrate having a rectangular shape including a first side, a second side neighboring the first side and connected to the first side, a third side facing the second side and neighboring the first side, and a fourth side connected to the second and the third sides and facing the first side, and a plurality of pads being formed on a surface of the substrate; a first duplexer configured to be mounted on the substrate for mounting a duplexer and to include a first antenna terminal, a first transmission terminal and a first reception terminal; and a second duplexer configured to be mounted on the substrate for mounting a duplexer and to include a second antenna terminal, a second transmission terminal and a second reception terminal. The first antenna terminal and the second antenna terminal are electrically connected to pads for an antenna, respectively, which belong to the plurality of pads and are disposed along the first side. The first reception terminal and the second reception terminal are electrically connected to pads for reception, respectively, which belong to the plurality of pads and are disposed along the second side. The first transmission terminal and the second transmission terminal are electrically connected to pads for transmission, respectively, which belong to the plurality of pads and are disposed along the third side.

A substrate for mounting a duplexer according to another aspect of the present invention includes a rectangular substrate including a first side, a second side neighboring the first side and connected to the first side, a third side facing the second side and neighboring the first side, and a fourth side connected to the second and the third sides and facing the first side, for mounting a plurality of duplexers; a plurality of pads for antennas which is adjacent to the first side and connected to antennas of the plurality of duplexers disposed along the first side; a plurality of pads for reception which is adjacent to the second side and connected to reception terminals of the plurality of duplexers disposed along the second side; a plurality of pads for transmission which is adjacent to the third side and connected to transmission terminals of the plurality of duplexers disposed along the third side; and a ground pad for grounding the plurality of duplexers disposed in a central part of the rectangular substrate.

### BRIEF DESCRIPTION OF THE DRAWINGS

- FIG. 1: is a block diagram showing the configuration of a duplexer device related to an embodiment of the present invention.
- FIG. 2: is a block diagram showing the configuration of the duplexer related to an embodiment of the present invention.
- FIG. 3: is a schematic diagram showing the configuration of a substrate for mounting a duplexer, which is related to an embodiment of the present invention.
- FIG. 4a: is a cross-sectional view of the substrate for mounting a duplexer, which is related to an embodiment of the present invention.
- FIG. 4b: is a schematic diagram showing the pattern of wires of the substrate for mounting a duplexer, which is related to an embodiment of the present invention.
- FIG. 4c: is a schematic diagram showing a modified example of the pattern of wires of the substrate for mounting a duplexer, which is related to an embodiment of the present invention.
- FIG. 5: is a schematic diagram showing the configuration of a duplexer device related to an embodiment of the present invention.
- FIG. 6a: is a graph showing a frequency characteristic on the transmission side of a first duplexer.
- FIG. 6b: is a graph showing a frequency characteristic on the reception side of the first duplexer.
- FIG. 6c: is a graph showing the isolation characteristic of the first duplexer.
- FIG. 7a: is a graph showing a frequency characteristic on the transmission side of a second duplexer.
- FIG. 7b: is a graph showing a frequency characteristic on the reception side of the second duplexer.
- FIG. 7c: is a graph showing the isolation characteristic of the second duplexer.

### Description of Reference Numerals

10: duplexer device
11: first duplexer
12: second duplexer
61 a, 61b: first frequency characteristic
62a, 62b: second frequency characteristic
63: first isolation characteristic
64: second isolation characteristic
71 a, 71b: third frequency characteristic
72a, 72b: fourth frequency characteristic
73: third isolation characteristic
74: fourth isolation characteristic
100: substrate for mounting a duplexer
101a, 101b, 101c, 101d, 101e, 101f, 101g, 101h, 101i, 101j, 101k, 101l, 101m: pad 111: first Rx filter
112: first Tx filter
113: first ANT terminal
114: first Rx terminal
115: first Tx terminal
121: second Rx filter
122: second Tx filter
123: second ANT terminal
124: second Rx terminal
125: second Tx terminal
200: first layer
300: second layer
310, 310': first reception-side ground wire
320, 320': second reception-side ground wire
400: third layer
410, 410': third reception-side ground wire
420, 420': fourth reception-side ground wire
430, 430': first transmission-side ground wire
440, 440': second transmission-side ground wire

### DETAILED DESCRIPTION

Exemplary embodiments of the present invention are described in detail below with reference to the accompanying drawings. Furthermore, in order to avoid inconvenience attributable to a redundant description, the same reference numeral is assigned to the same part or an equivalent thereof in each figure and a description thereof is omitted.

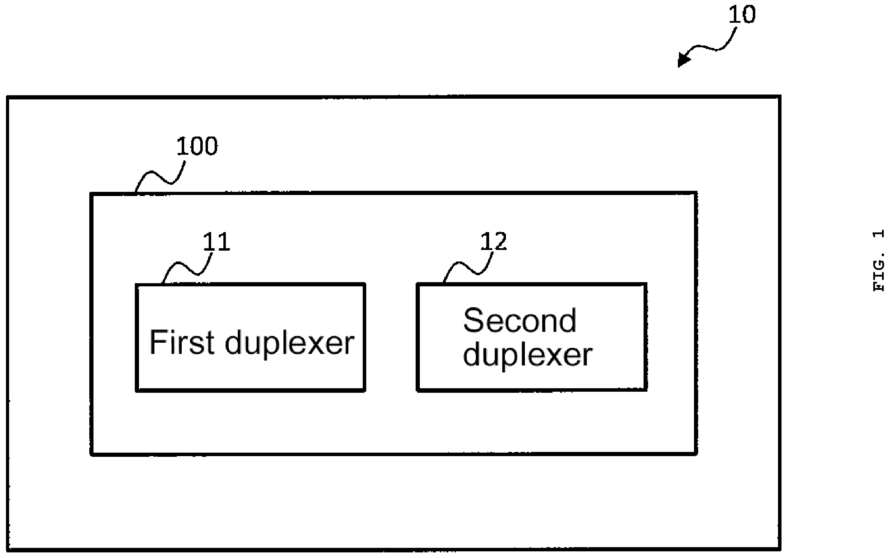

FIG. 1 is a block diagram showing the configuration of a duplexer device 10 related to an embodiment of the present invention.

As shown in FIG. 1, the duplexer device 10 includes a first duplexer 11, a second duplexer 12 and a substrate 100 for mounting a duplexer. The duplexer device 10 is configured by mounting the first duplexer 11 and the second duplexer 12 on the substrate 100 for mounting a duplexer.

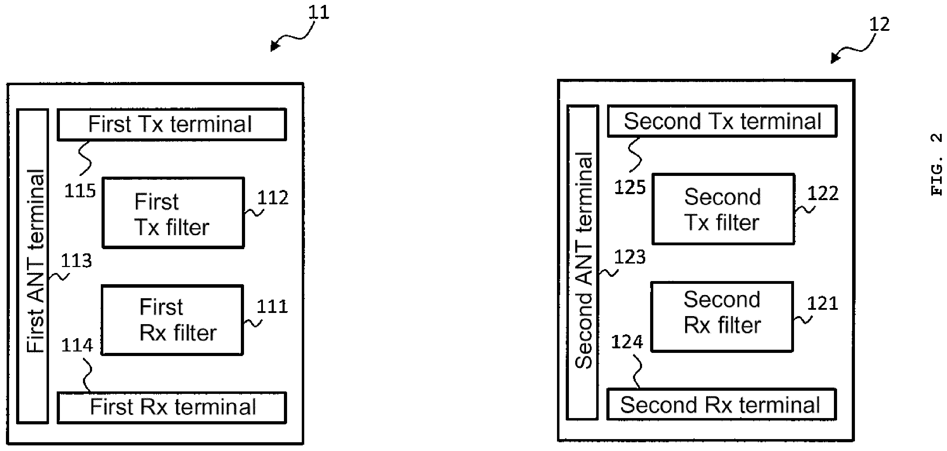

FIG. 2 is a block diagram showing the configuration of the first duplexer 11 and the second duplexer 12.

As shown in FIG. 2, the first duplexer 11 includes a first Rx filter 111, a first Tx filter 112, a first ANT terminal 113, a first Rx terminal 114 and a first Tx terminal 115.

The first Rx filter 111 is a filter that pass a first reception band. In general, the first Rx filter 111 may be configured by a double mode type SAW device, but is not limited thereto. The first reception band is not especially limited and may be properly designed depending on a required band.

The first Tx filter 112 is a filter that pass a first transmission band. In general, the first Tx filter 112 may be configured by a ladder type SAW device, but is not limited thereto. The first transmission band is not especially limited and may be properly designed depending on a required band.

The first ANT terminal 113 is a terminal connected to the antenna of a communication device, the first Rx filter 111 and the first Tx filter 112.

The first Rx terminal 114 is a terminal connected to the first Rx filter 111. That is, the first Rx terminal 114 is connected to the first ANT terminal 113 with the first Rx filter 111 interposed between them.

The first Tx terminal 115 is a terminal connected to the first Tx filter 112. That is, the first Tx terminal 115 is connected to the first ANT terminal 113 with the first Tx filter 112 interposed between them.

The second duplexer 12 includes a second Rx filter 121, a second Tx filter 122, a second ANT terminal 123, a second Rx terminal 124 and a second Tx terminal 125.

The second Rx filter 121 is a filter that pass a second reception band. In general, the second Rx filter 121 may be configured by a double mode type SAW device, but is not limited thereto. Like the first reception band, the second reception band is not especially limited and may be properly designed depending on a required band. Furthermore, the second reception band may be the same as or different from the first reception band.

The second Tx filter 122 is a filter that pass a second transmission band. In general, the second Tx filter 122 may be configured by a ladder type SAW device, but is not limited thereto. Like the first transmission band, the second transmission band is not especially limited and may be properly designed depending on a required band. Furthermore, the second transmission band may be the same as or different from the first transmission band.

The second ANT terminal 123 is a terminal connected to the antenna of a communication device, the second Rx filter 121 and the second Tx filter 122.

The second Rx terminal 124 is a terminal connected to the second Rx filter 121. That is, the second Rx terminal 124 is connected to the second ANT terminal 123 with the second Rx filter 121 interposed between them.

The second Tx terminal 125 is a terminal connected to the second Tx filter 122. That is, the second Tx terminal 125 is connected to the second ANT terminal 123 with the second Tx filter 122 interposed between them.

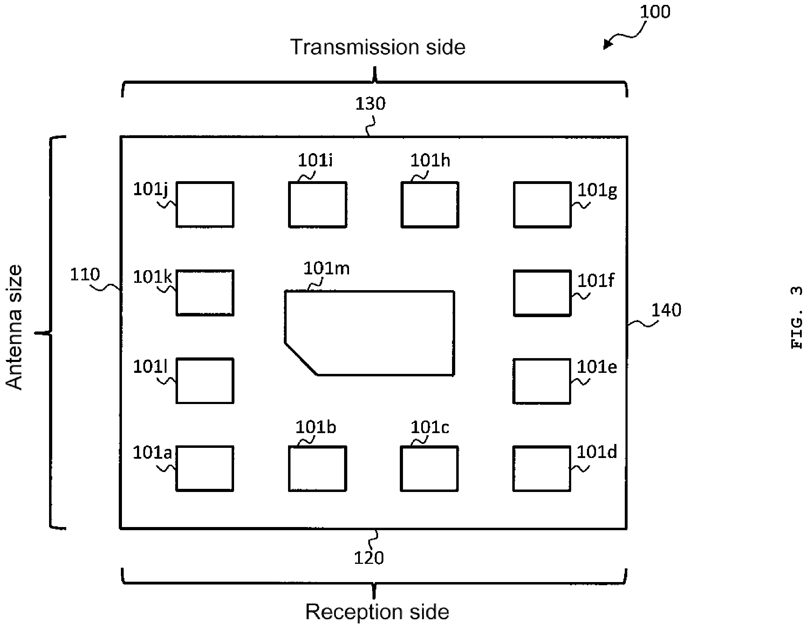

FIG. 3 is a schematic diagram showing an example of a detailed configuration of the substrate 100 for mounting a duplexer, which is related to an embodiment of the present invention.

As shown in FIG. 3, the substrate 100 for mounting a duplexer is a rectangular substrate including a first side 110, a second side 120, a third side 130 and a fourth side 140.

The second side 120 is a side connected to the first side 110. The third side 130 is a side that is connected to the first side 110 and that faces the second side 120. The fourth side 140 is a side that is connected to the second side 120 and the third side 130 and that faces the first side 110. Furthermore, a plurality of pads has been disposed on a surface of the substrate 100 for mounting a duplexer.

The pads include a transmission pad for supplying output from a power amplifier (not shown) to the first Tx terminal 115 and second Tx terminal 125 of the first duplexer 11 and the second duplexer 12. Furthermore, the pads include a reception pad for supplying a linear amplifier (not shown) with reception output applied to the first Rx terminal 114 and second Rx terminal 124 of the first duplexer 11 and the second duplexer 12. Furthermore, the pads include an antenna pad connected to the first ANT terminal 113 and the second ANT terminal 123.

Specifically, a pad 101a, a pad 101j, a pad 101k and a pad 101l have been disposed on a surface of the substrate 100 for mounting a duplexer along the first side 110. Furthermore, a pad 101b, a pad 101c and a pad 101 d have been disposed on the surface of the substrate 100 along the second side 120 connected to the first side 110. Furthermore, a pad 101 g, a pad 101 h and a pad 101i have been disposed on the surface of the substrate 100 along the third side 130 that is connected to the first side 110 and that faces the second side 120. Furthermore, a pad 101e and a pad 101f have been disposed on the surface of the substrate 100 along the fourth side 140 that faces the first side 110 and that is connected to the second side 120 and the third side 130. Furthermore, a pad 101m has been disposed at the center of the surface of the substrate 100. That is, the 13 pads have been disposed on the surface of the illustrated substrate 100 for mounting a duplexer. The substrate 100 for mounting a duplexer illustrated in FIG. 3 is illustrative, and the number of pads may be randomly changed depending on the design.

The pads 101 a to 101 m disposed on the surface of the substrate 100 for mounting a duplexer are described in more detail below.

The pad 101a, the pad 101j, the pad 101k and the pad 101l disposed along the first side 110 are pads for an ANT terminal to which the first ANT terminal 113 and the second ANT terminal 123 are connected. That is, the pads for an ANT terminal are disposed along the same side. Furthermore, a pad that belongs to the pad 101a, the pad 101j, the pad 101k and the pad 101l and that is not connected to the first ANT terminal 113 and the second ANT terminal 123 is a pad for ground.

The pad 101b, the pad 101c and the pad 101d disposed along the second side 120 are pads for an Rx terminal to which the first Rx terminal 114 and the second Rx terminal 124 are connected. That is, the pads for an Rx terminal are disposed independently of a pad for reception and a pad for an antenna along the same side. Furthermore, a pad that belongs to the pad 101b, the pad 101c and the pad 101 d and that is not connected to the first Rx terminal 114 and the second Rx terminal 124 is a pad for ground.

The pad 101 g, the pad 101 h and the pad 101i disposed along the third side 130 are pads for a Tx terminal to which the first Tx terminal 115 and the second Tx terminal 125 are connected. That is, the pads for a Tx terminal are disposed along a side different from that of the pad for reception and the pad for an antenna and also disposed along the same side. Furthermore, a pad that belongs to the pad 101 g, the pad 101 h and the pad 101i and that is not connected to the first Tx terminal 115 and the second Tx terminal 125 is a pad for ground.

The pad 101e and the pad 101f disposed along the fourth side 140 are pads for ground.

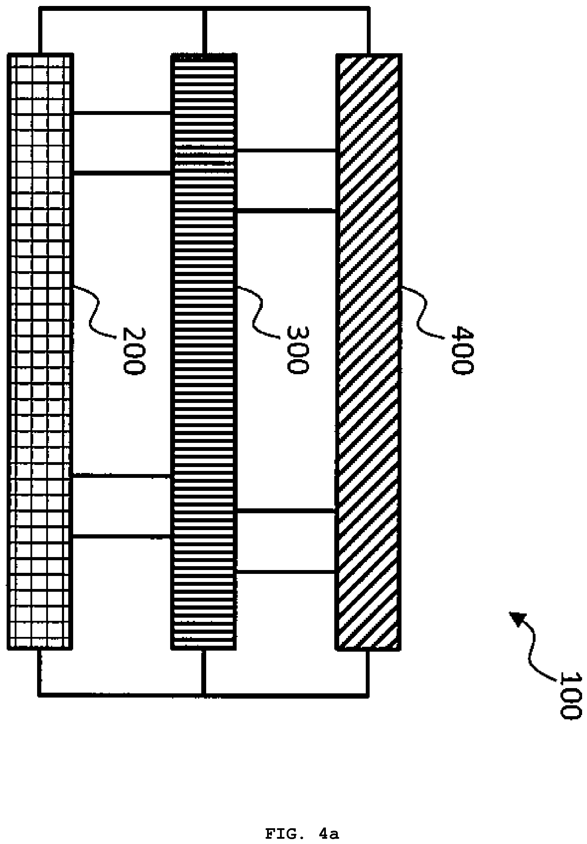

FIG. 4a is a schematic diagram of a cross section of the substrate 100 for mounting a duplexer.

As shown in FIG. 4a, the substrate 100 for mounting a duplexer includes a first layer 200, a second layer 300 and a third layer 400. The substrate 100 for mounting a duplexer has been illustrated as including the three layers hereinafter, but is illustrative and is not limited thereto.

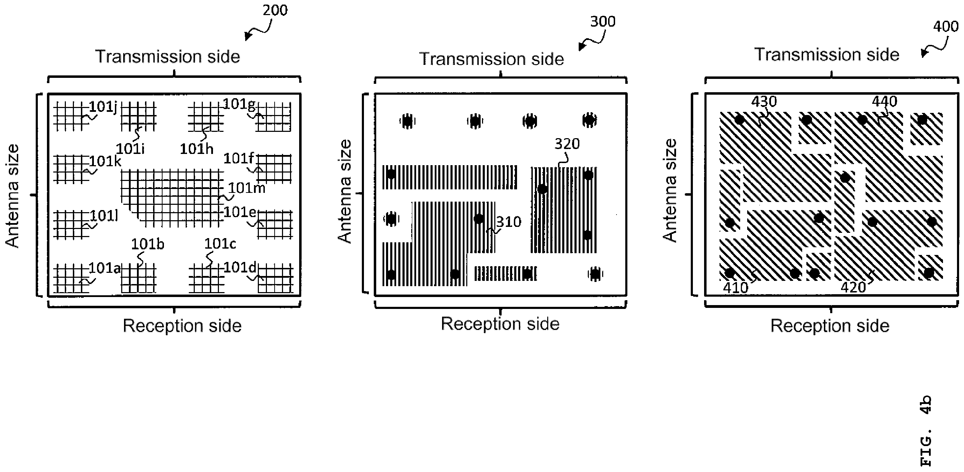

FIG. 4b is a schematic diagram of the first layer 200, the second layer 300 and the third layer 400, which is seen from the top. A dark circle shown in FIG. 4b indicates a via hole, and the first layer 200, the second layer 300 and the third layer 400 are connected via the via holes.

The first layer 200 is a layer forming the pads disposed on the surface of the substrate 100 for mounting a duplexer. That is, the first layer 200 corresponds to the surface of the substrate 100 for mounting a duplexer in FIG. 3 and shows the pads 101a to 101m.

The second layer 300 diagramatically shows the pattern of the pad for an antenna, the pad for transmission, the pad for reception, and ground wires. The illustrated second layer 300 includes a first reception-side ground wire 310 and a second reception-side ground wire 320. Furthermore, via holes connected to the respective pads 101g to 101j on the transmission side of the first layer 200 are formed on the transmission side of the second layer 300. Meanwhile, via holes connected to the respective pads 101c and 101 d on the reception side of the first layer 200 are formed on the reception side of the second layer 300. The via holes are disposed closer to the fourth side 140 than to the center of the second side 120 of the substrate 100 for mounting a duplexer.

The first reception-side ground wire 310 of the second layer 200 is a ground wire connected to a ground on the reception side of the first duplexer 11. Furthermore, the pad 101 a, the pad 101 b and the pad 101 m are connected to the first reception-side ground wire 310. That is, in the second layer 300, the pad 101 a, the pad 101b and the pad 101m are grounds on the reception side of the first duplexer 11.

The second reception-side ground wire 320 is a ground wire connected to a ground on the reception side of the second duplexer 12. Furthermore, the pad 101e, the pad 101f and the pad 101m are connected to the second reception-side ground wire 320. That is, in the second layer 300, the pad 101e, the pad 101f and the pad 101m are grounds on the reception side of the second duplexer 12.

As shown in FIG. 4b, the first reception-side ground wire 310 and the second reception-side ground wire 320 are not connected, but have been independently disposed. Furthermore, in the second layer 300, the pattern and the via hole corresponding to the pad 101 c for reception of the first duplexer 11 and the pad 101 d for reception of the second duplexer 12 are independent are disposed closer to the fourth side 140 than to the center of the second side 120.

Like the second layer 300, the third layer 400 shows the pattern of wires corresponding to a pad for an antenna, a pad for transmission, a pad for reception and ground pads. The third layer 400 includes a third reception-side ground wire 410, a fourth reception-side ground wire 420, a first transmission-side ground wire 430 and a second transmission-side ground wire 440. The pads are connected to the ground wires 410 to 440 with via holes interposed therebetween as grounds for reception and transmission.

Specifically, the third reception-side ground wire 410 is a ground wire to which a ground pad on the reception side of the first duplexer 11 is connected. Furthermore, the pad 101a, the pad 101 b and the pad 101 m are connected to the third reception-side ground wire 410 with via holes interposed therebetween. That is, the third reception-side ground wire 410 of the third layer 400 is a ground wire on the reception side, which is connected to the pad 101 a, the pad 101b and the pad 101m.

The fourth reception-side ground wire 420 is a ground wire to which a ground on the reception side of the second duplexer 12 is connected. Furthermore, the fourth reception-side ground wire 420 is connected to the pad 101e and the pad 101m with via holes interposed therebetween. That is, in the third layer 400, the pad 101 e and the pad 101 m form ground pads on the reception side of the second duplexer 12.

As shown in FIG. 4b, the third reception-side ground wire 410 and the fourth reception-side ground wire 420 are not connected, but have been independently disposed. That is, the grounds on the reception side of the first duplexer 11 and the second duplexer 12 are independent in the third layer 400 in addition to the second layer 300.

The first transmission-side ground wire 430 is a ground wire to which a ground on the transmission side of the first duplexer 11 is connected. Furthermore, the pad 101j is connected to the first transmission-side ground wire 430 with a via hole interposed therebetween. That is, in the first transmission-side ground wire 430, the pad 101j is a ground on the transmission side of the first duplexer 11.

The second transmission-side ground wire 440 is a ground wire to which a ground on the transmission side of the second duplexer 12 is connected. Furthermore, the pad 101 h is connected to the second transmission-side ground wire 440 with a via hole interposed therebetween. That is, in the second transmission-side ground wire 440, the pad 101 h is a ground on the transmission side of the second duplexer 12.

As shown in FIG. 4b, the first transmission-side ground wire 430 and the second transmission-side ground wire 440 are not connected, but have been independently disposed. That is, in the third layer 400, the grounds on the transmission side of the first duplexer 11 and second duplexer 12 are independent. Accordingly, in the duplexer device 10, the grounds of the first duplexer 11 and the second duplexer 12 are independent.

From the above description, the pad 101l and the pad 101k that belong to the pads disposed along the first side 110 and that are not connected to a ground are pads for an antenna to which the first ANT terminal 113 and the second ANT terminal 123 are connected.

The pad 101c and the pad 101 d that belong to the pads disposed along the second side 120 and that are not connected to a ground are pads for reception to which the first Rx terminal 114 and the second Rx terminal 124 are connected.

The pad 101i and the pad 101g that belong to the pads disposed along the third side 130 and that are not connected to a ground are pads for transmission to which the first Tx terminal 115 and the second Tx terminal 125 are connected.

In the substrate 100 for mounting a duplexer, the pad for an antenna and the pad for reception are not connected, but are connected within the first duplexer 11 and the second duplexer 12 mounted on the substrate 100 for mounting a duplexer. Likewise, the pad for an antenna and the pad for transmission are not connected, but are connected within the first duplexer 11 and the second duplexer 12 mounted on the substrate 100 for mounting a duplexer.

Furthermore, the pattern of the pad for an antenna, the pad for transmission, the pad for reception and the ground wires shown in FIG. 4b are illustrative, and each pattern may be randomly changed depending on the design.

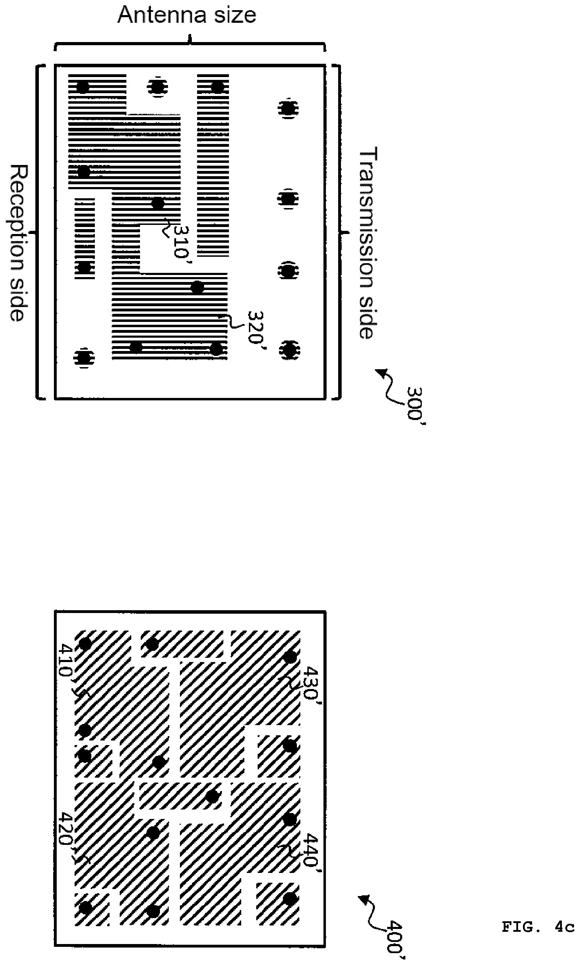

FIG. 4c shows a substrate for mounting a duplexer related to another embodiment of the present invention. Only a second layer 300' and third layer 400' are diagramatically shown in FIG. 4c.

The second layer 300' is a modified example of the second layer 300, and includes a first reception-side ground wire 310' and a second reception-side ground wire 320'. Furthermore, the second layer 300' and the third layer 400' shown in FIG. 4c are only modified examples of the second layer 300 and the third layer 400 and do not limit a modification example of the present invention.

As shown in FIG. 4c, the first reception-side ground wire 310' is connected to the second reception-side ground wire 320'. Accordingly, in the second layer 300', the pad 101a, the pad 101b, the pad 101e, the pad 101f and the pad 101m are common. That is, in the second layer 300', grounds on the reception side of the first duplexer 11 and the second duplexer 12 are common.

The third layer 400' is a modified example of the third layer 400, and includes a third reception-side ground wire 410', a fourth reception-side ground wire 420', a first transmission-side ground wire 430' and a second transmission-side ground wire 440'.

As shown in FIG. 4c, the third reception-side ground wire 410' is connected to the fourth reception-side ground wire 420'. Accordingly, in the third layer 400', the pad 101 a, the pad 101b, the pad 101e and the pad 101m are common. That is, grounds on the reception side of the first duplexer 11 and the second duplexer 12 are common in the third layer 400' in addition to the second layer 300'.

The first transmission-side ground wire 430' and the second transmission-side ground wire 440' are the same as the first transmission-side ground wire 430 and the second transmission-side ground wire 440. Furthermore, in FIG. 4c, the pattern of a pad for an antenna, a pad for transmission and a pad for reception is the same as that of FIG. 4b. In particular, the pad for reception disposed along the second side 120 of the substrate for mounting a duplexer is disposed closer to the fourth side 140 than to the center of the second side 120. As described above, the pad for reception is disposed along one side of the substrate for mounting a duplexer and is spaced apart from the first side 110 on which the pad for antenna is disposed. Accordingly, it was found that an isolation characteristic between the first duplexer 11 and the second duplexer 12 could be improved.

Furthermore, in an embodiment of the present invention, a ground on the reception side of the first duplexer 11 and the second duplexer 12 may be independent or common.

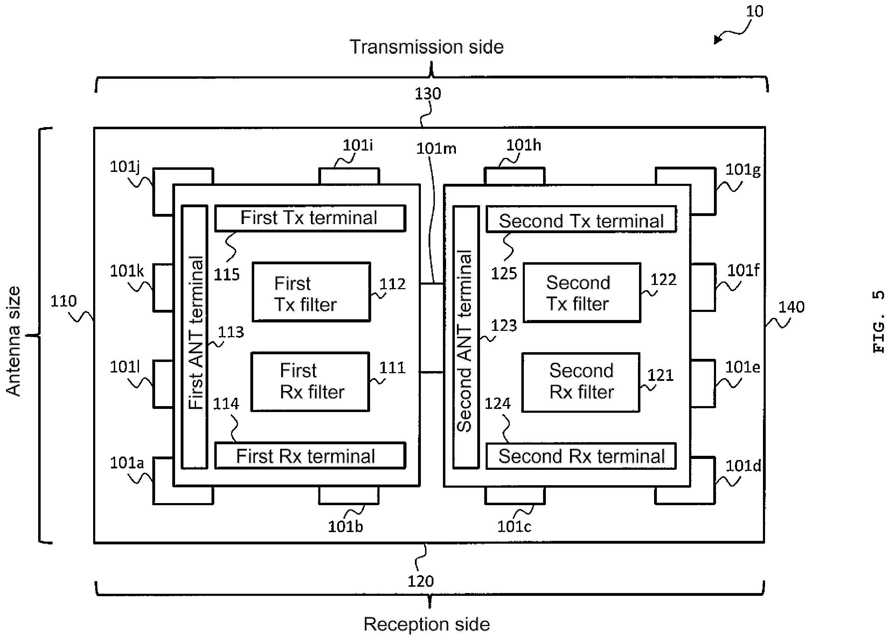

FIG. 5 is a schematic diagram showing an example of the configuration of the duplexer device 10.

The first ANT terminal 113 is electrically connected to any one of the pad 101a, the pad 101j, the pad 101k and the pad 101l. For example, if the first ANT terminal 113 is electrically connected to the pad 101l, the second ANT terminal 123 is electrically connected to any one of the pad 101a, the pad 101j and the pad 101k. That is, the first ANT terminal 113 and the second ANT terminal 123 are electrically connected to pads disposed along the first side 110.

In this example, the first Rx terminal 114 of the first duplexer 11 is electrically connected to any one of the pad 101 c and the pad 101 d disposed on the side of the second duplexer 12. For example, if the first Rx terminal 114 is connected to the pad 101c, the second Rx terminal 124 is electrically connected to the pad 101d. That is, the first Rx terminal 114 and the second Rx terminal 124 are electrically connected to the pads disposed along the second side 120 and are also connected to the pads on the side of the second duplexer 12, which have been sufficiently spaced apart from the ANT terminal. Furthermore, the first Rx terminal 114 may be connected to the pad 101b on the side of the first duplexer 11 of the second side 120.

The first Tx terminal 115 is electrically connected to any one of the pad 101 g, the pad 101 h and the pad 101i. For example, if the first Tx terminal 115 is electrically connected to the pad 101i, the second Tx terminal 125 is electrically connected to any one of the pad 101 g and the pad 101 h. That is, the first Tx terminal 115 and the second Tx terminal 125 are electrically connected to the pads disposed along the third side 130.

Specifically, the first ANT terminal 113 and the second ANT terminal 123 have only to be electrically connected to the pads disposed on the same side. Furthermore, the first Rx terminal 114 and the second Rx terminal 124 have only to be electrically connected to the pads disposed on the same side. Furthermore, the first Tx terminal 115 and the second Tx terminal 125 have only to be electrically connected to the pads disposed the same side.

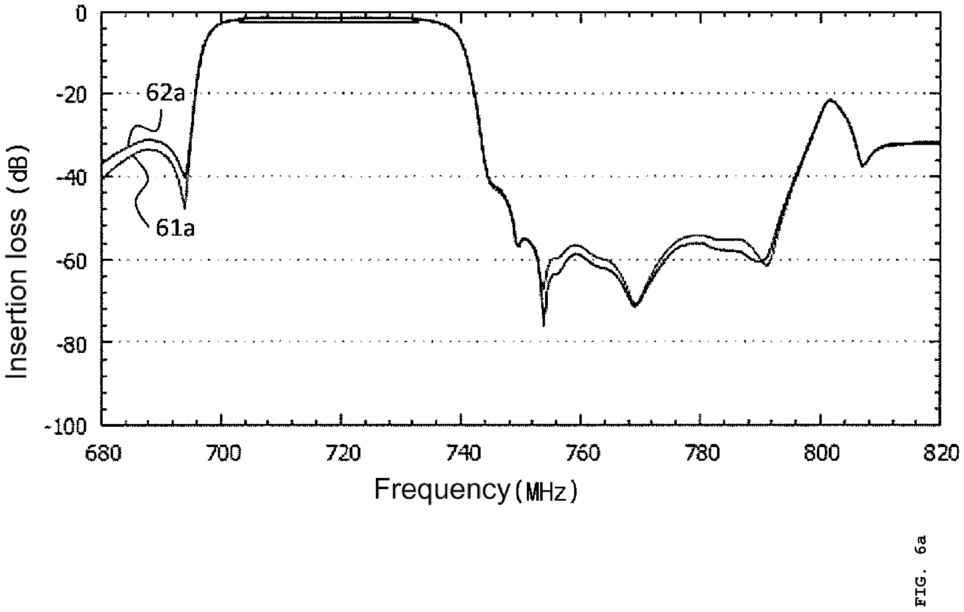

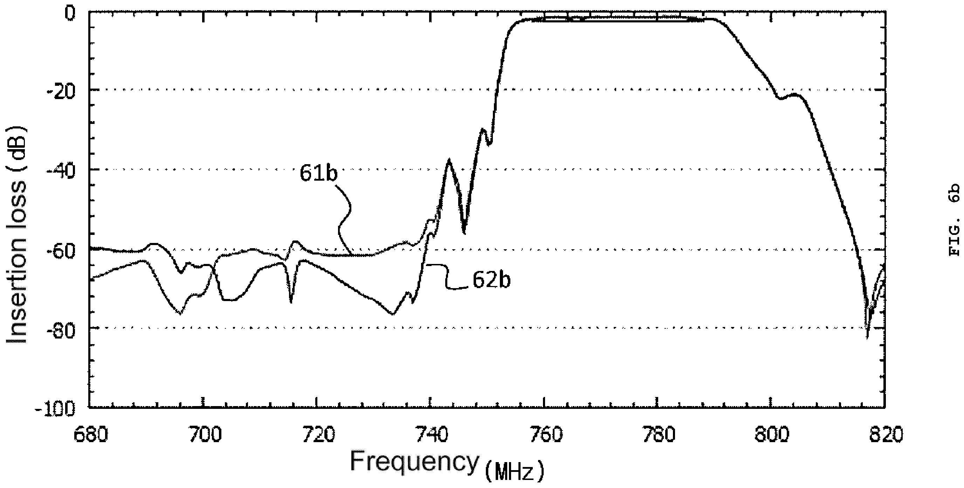

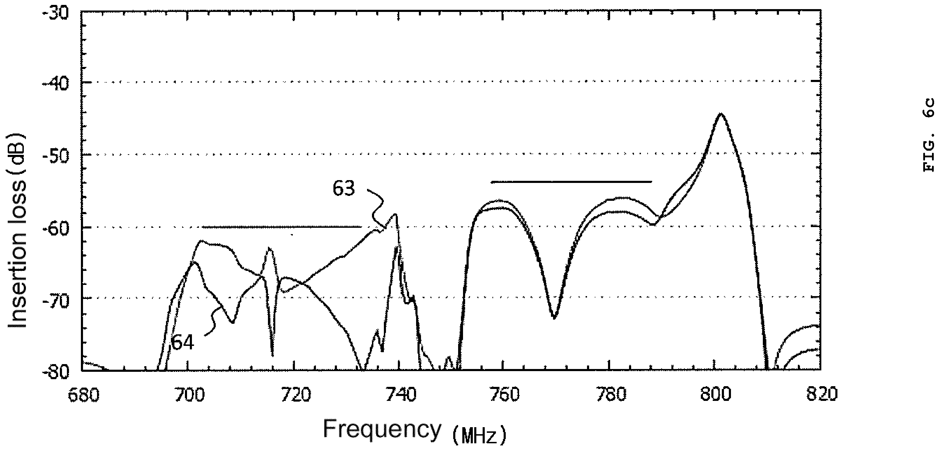

FIGS. 6a, 6b, and 6c are graphs showing the frequency characteristics and isolation characteristics of the first duplexer 11 in the duplexer device 10. In the graphs of FIGS. 6a to 6c, a horizontal axis is a frequency MHz and a vertical axis is an insertion loss dB.

In the graph of FIG. 6a, the horizontal axis is about 680 to 820 MHz and the vertical axis is -100 to 0 dB. FIG. 6a shows a first frequency characteristic 61a and a second frequency characteristic 62a. The first frequency characteristic 61 a and the second frequency characteristic 62a correspond to frequency characteristics on the transmission side of the first duplexer 11.

In the case where the first frequency characteristic 61 a is obtained and the case where the second frequency characteristic 62a is obtained, the connection of the first duplexer 11, the second duplexer 12 and the substrate 100 for mounting a duplexer is different.

Specifically, in the case where the first frequency characteristic 61a is obtained, in FIG. 5, the first ANT terminal 113 is connected to the pad 101l and the second ANT terminal 123 is connected to the pad 101 k. Furthermore, the first Rx terminal 114 is connected to the pad 101b and the second Rx terminal 124 is connected to the pad 101 d. That is, the second Rx terminal 124 is connected to a pad that belongs to the pads disposed along the second side 120 and that is located farthest from the first side 110. Furthermore, the first Tx terminal 115 is connected to the pad 101i and the second Tx terminal 125 is connected to the pad 101 g.

In contrast, the case where the second frequency characteristic 62a is obtained is different from the case where the first frequency characteristic 61a is obtained in that the first Rx terminal 114 is connected to the pad 101c. That is, in this case, the first Rx terminal 114 is connected to a pad that belongs to the pads disposed along the second side 120 and that is adjacent to a pad to which the second Rx terminal 124 is connected.

In FIG. 6a, the range of 703 to 733 MHz is the transmission band of the first duplexer 11. As shown in FIG. 6a, insertion losses in the transmission bands of the first frequency characteristic 61 a and the second frequency characteristic 62a are almost identical.

In the graph of FIG. 6b, the horizontal axis is about 680 to 820 MHz and the vertical axis is -100 to 0 dB. FIG. 6b shows a first frequency characteristic 61b and a second frequency characteristic 62b. The first frequency characteristic 61 b and the second frequency characteristic 62b correspond to frequency characteristics on the reception side of the first duplexer 11.

The connection of the first duplexer 11, the second duplexer 12 and the substrate 100 for mounting a duplexer in the case where the first frequency characteristic 61 b is obtained is the same as that in the case where the first frequency characteristic 61 a of FIG. 6a is obtained.

The connection of the first duplexer 11, the second duplexer 12 and the substrate 100 for mounting a duplexer in the case where the second frequency characteristic 62b is obtained the same as that in the case where the second frequency characteristic 62a of FIG. 6a is obtained.

In FIG. 6b, the range of 758 to 788 MHz is the reception band of the first duplexer 11. As shown in FIG. 6b, insertion losses in the reception bands of the first frequency characteristic 61 b and the second frequency characteristic 62b are almost identical.

That is, FIGS. 6a and 6b illustrate that although the first Rx terminal 114 is connected to a pad distant from the first side 110, frequency characteristics on the transmission side and reception side of the first duplexer 11 are rarely changed.

In the graph of FIG. 6c, the horizontal axis is about 680 to 820 MHz and the vertical axis is -80 to -30 dB. FIG. 6c shows a first isolation characteristic 63 and a second isolation characteristic 64. The first isolation characteristic 63 and the second isolation characteristic 64 correspond to isolation characteristics of the first duplexer 11.

The connection of the first duplexer 11, the second duplexer 12 and the substrate 100 for mounting a duplexer in the case where the first isolation characteristic 63 is obtained is the same as that in the case where the first frequency characteristic 61 a of FIG. 6a is obtained.

The connection of the first duplexer 11, the second duplexer 12 and the substrate 100 for mounting a duplexer in the case where the second isolation characteristic 64 is obtained is the same as that in the case where the first frequency characteristic 62a of FIG. 6a is obtained.

As shown in FIG. 6c, the second isolation characteristic 64 is about 10 dB better than the first isolation characteristic 63 on average in the transmission band of 703 to 733 MHz. That is, FIG. 6c illustrates that the isolation characteristic of the first duplexer 11 is improved because the first Rx terminal 114 is connected to a pad distant from the first side 110. Furthermore, as shown in FIG. 6c, the first isolation characteristic 63 and the second isolation characteristic 64 are almost identical in the reception band of 758 to 788 MHz.

The reason for this is that since the first Rx terminal 114 is spaced apart from the first side 110, the distance between the first Rx terminal 114 and the first ANT terminal 113 and the second ANT terminal 123 is increased and thus interference between the signals of the terminals has been suppressed. For this reason, the pads disposed along the second side 120 to which the first Rx terminal 113 and the second Rx terminal 114 are connected may be spaced apart from the first side 110 and may be disposed closer to the fourth side 140. Furthermore, one of the first Rx terminal 114 and the second Rx terminal 124 may be connected to a pad located farthest from the first side 110, and the other thereof may be connected to a pad adjacent to the pad located farthest from the first side 110.

Furthermore, in the substrate 100 for mounting a duplexer, the pad 101b may be used as the ground of the first duplexer 11 by connecting the first Rx terminal 114 to the pad 101 c not the pad 101 b. Accordingly, the first duplexer 11 can operate stably because the ground is strengthened.

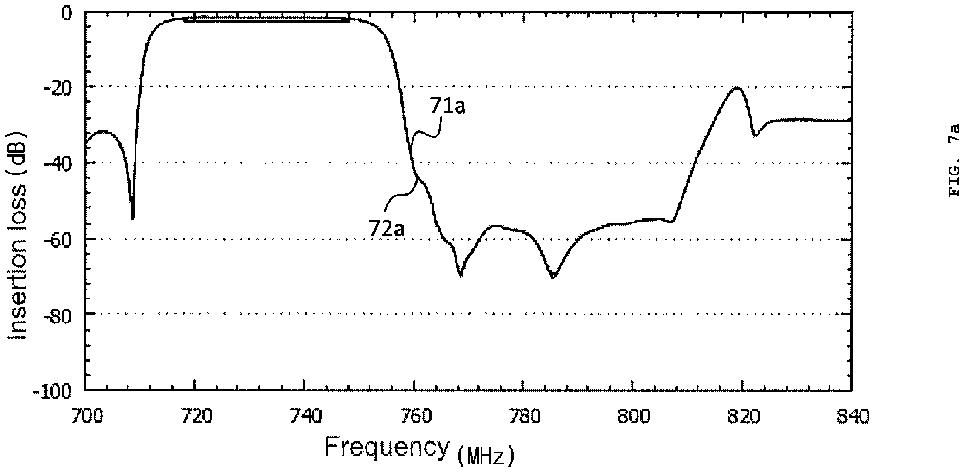

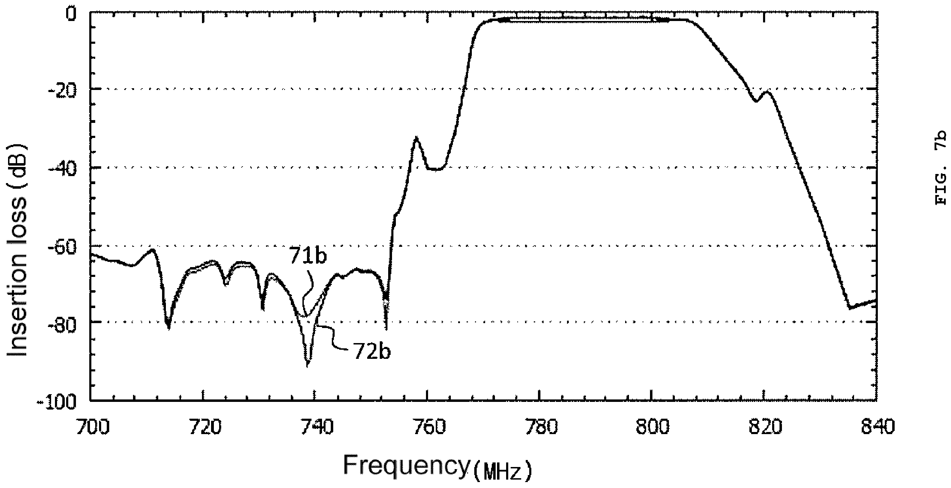

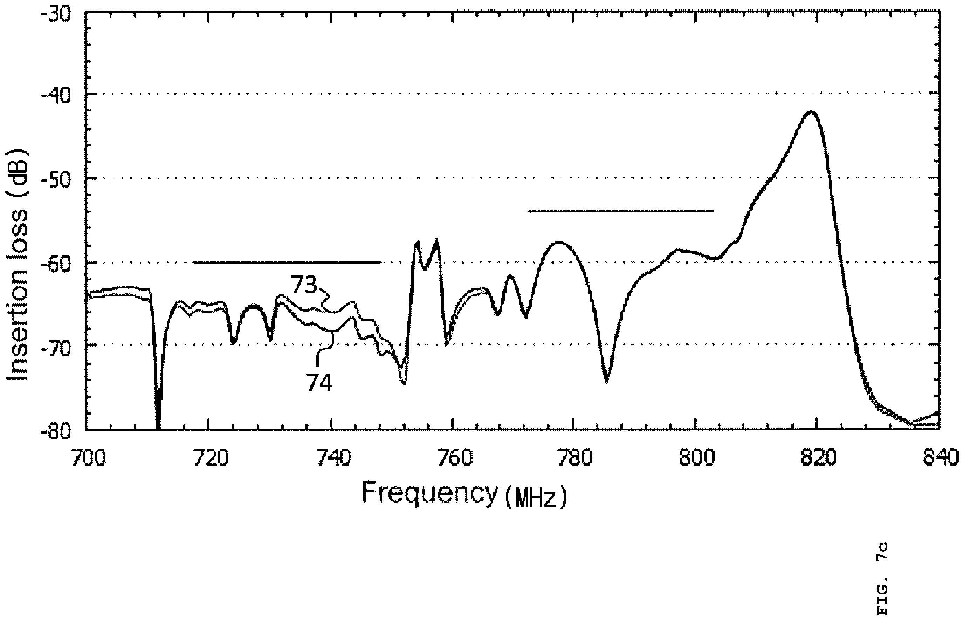

FIGS. 7a, 7b and 7c are graphs showing the frequency characteristics and isolation characteristics of the second duplexer 12 in the duplexer device 10. In the graphs of FIGS. 7a to 7c, a horizontal axis is a frequency MHz and a vertical axis is an insertion loss dB.

In the graph of FIG. 7a, a horizontal axis is about 700 to 840 MHz and a vertical axis is -100 to 0 dB.

FIG. 7a shows a third frequency characteristic 71 a and a fourth frequency characteristic 72a.

The connection of the first duplexer 11, the second duplexer 12 and the substrate 100 for mounting a duplexer in the case where the third frequency characteristic 71a is obtained is the same as that in the case where the first frequency characteristic 61 a of FIG. 6a is obtained.

The connection of the first duplexer 11, the second duplexer 12 and the substrate 100 for mounting a duplexer in the case where the fourth frequency characteristic 72a is obtained is the same as that in the case where the second frequency characteristic 62a of FIG. 6a is obtained.

In the third frequency characteristic 71a and the fourth frequency characteristic 72a, the range of 718 to 748 MHz is the transmission band of the second duplexer 12. As shown in FIG. 7a, insertion losses in the transmission bands of the third frequency characteristic 71 a and the fourth frequency characteristic 72a are almost identical.

In the graph of FIG. 7b, the horizontal axis is about 700 to 840 MHz and the vertical axis is -100 to 0 dB. FIG. 7b shows a third frequency characteristic 71b and a fourth frequency characteristic 72b. The third frequency characteristic 71 b and the fourth frequency characteristic 72b correspond to frequency characteristics on the reception side of the second duplexer 12.

The connection of the first duplexer 11, the second duplexer 12 and the substrate 100 for mounting a duplexer in the case where the third frequency characteristic 71 b is obtained is the same as that in the case where the third frequency characteristic 71a of FIG. 7a is obtained.

The connection of the first duplexer 11, the second duplexer 12 and the substrate 100 for mounting a duplexer in the case where the fourth frequency characteristic 72b is obtained is the same as that in the case where the fourth frequency characteristic 72a of FIG. 7a is obtained.

In FIG. 7b, the range of 773 to 803 MHz is the reception band of the second duplexer 12. As shown in FIG. 7b, insertion losses in the reception bands of the third frequency characteristic 71 b and the fourth frequency characteristic 72b are almost identical. That is, FIGS. 7a and 7b show that although the first Rx terminal 114 is connected to a pad distant from the first side 110, frequency characteristics on the transmission side and reception side of the second duplexer 12 are rarely changed.

In the graph of FIG. 7c, the horizontal axis is about 700 to 840 MHz and the vertical axis is - 80 to -30 dB. FIG. 7c shows a third isolation characteristic 73 and a fourth isolation characteristic 74. The third isolation characteristic 73 and the second isolation characteristic 74 correspond to isolation characteristics of the second duplexer 12.

The connection of the first duplexer 11, the second duplexer 12 and the substrate 100 for mounting a duplexer in the case where the third isolation characteristic 73 is obtained is the same as that in the case where the third frequency characteristic 71 a of FIG. 7a is obtained.

The connection of the first duplexer 11, the second duplexer 12 and the substrate 100 for mounting a duplexer in the case where the fourth isolation characteristic 74 is obtained is the same as that in the case where the fourth frequency characteristic 72a of FIG. 7a is obtained.

As shown in FIG. 7c, insertion losses in the transmission band of 718 to 748 MHz and reception band of 773 to 803 MHz of the third isolation characteristic 73 and the fourth isolation characteristic 74 are almost identical. That is, FIG. 7c shows that the isolation characteristic of the second duplexer 12 is rarely changed although the first Rx terminal 114 is connected to a pad distant from the first side 110.

Accordingly, the duplexer device 10 can obtain the most excellent isolation characteristic by connecting the second Rx terminal 124 to a pad located farthest from the first side 110 and connecting the first Rx terminal 114 to a pad adjacent to the pad to which the second Rx terminal 124 is connected.

In accordance with the present invention, an excellent isolation characteristic in a modulated dual duplexer device can be easily obtained.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A duplexer device, comprising:
a substrate for mounting a duplexer, the substrate having a rectangular shape comprising a first side, a second side neighboring the first side and connected to the first side, a third side facing the second side and neighboring the first side, and a fourth side connected to the second and the third sides and facing the first side, and a plurality of pads being formed on a surface of the substrate;
a first duplexer configured to be mounted on the substrate for mounting a duplexer and to comprise a first antenna terminal, a first transmission terminal and a first reception terminal; and
a second duplexer configured to be mounted on the substrate for mounting a duplexer and to comprise a second antenna terminal, a second transmission terminal and a second reception terminal,
wherein the first antenna terminal and the second antenna terminal are electrically connected to pads for an antenna, respectively, which belong to the plurality of pads and are disposed along the first side,
the first reception terminal and the second reception terminal are electrically connected to pads for reception, respectively, which belong to the plurality of pads and are disposed along the second side, and
the first transmission terminal and the second transmission terminal are electrically connected to pads for transmission, respectively, which belong to the plurality of pads and are disposed along the third side.

2. The duplexer device of claim 1, wherein a first one of the first reception terminal and the second reception terminal is electrically connected to a pad which belongs to the pads disposed along the second side and is spaced apart from the first side.

3. The duplexer device of claim 2, wherein a second one of the first reception terminal and the second reception terminal is electrically connected to a pad adjacent to the pad to which the first one is connected.

4. The duplexer device of claim 1, wherein a pad for ground for grounding one of the first and the second duplexers is interposed between the pad for reception disposed along the second side and the pad for an antenna disposed along the first side.

5. The duplexer device of claim 1, wherein the pad for reception disposed along the second side is disposed closer to the fourth side.

6. The duplexer device of claim 1, wherein a ground on a reception side of the first duplexer and a ground on a reception side of the second duplexer are independently disposed on the substrate for mounting a duplexer.

7. The duplexer device of claim 1, wherein a ground on a reception side of the first duplexer and a ground on a reception side of the second duplexer are disposed in common on the substrate for mounting a duplexer.

8. The duplexer device of claim 1, wherein a pass band on a reception side and a pass band on a transmission side are different in the first duplexer and the second duplexer.

9. A substrate for mounting a plurality of duplexers, comprising:
a rectangular substrate comprising a first side, a second side neighboring the first side and connected to the first side, a third side facing the second side and neighboring the first side, and a fourth side connected to the second and the third sides and facing the first side, for mounting a plurality of duplexers;
a plurality of pads for antennas which is adjacent to the first side and connected to antennas of the plurality of duplexers disposed along the first side;
a plurality of pads for reception which is adjacent to the second side and connected to reception terminals of the plurality of duplexers disposed along the second side;
a plurality of pads for transmission which is adjacent to the third side and connected to transmission terminals of the plurality of duplexers disposed along the third side; and
a ground pad for grounding the plurality of duplexers disposed in a central part of the rectangular substrate.

10. The substrate of claim 10, wherein one of the plurality of pads for reception disposed along the second side is disposed at a location near the fourth side which is spaced apart from the plurality of pads for antennas disposed along the first side.

11. The substrate of claim 11, wherein some of the plurality of pads for reception disposed along the second side are adjacent to each other.

12. The substrate of claim 10, wherein a ground pad for grounding one of the plurality of duplexers is interposed between the plurality of pads for reception disposed along the second side and the plurality of pads for antennas disposed along the first side.

13. The substrate of claim 10, wherein the plurality of pads for reception disposed along the second side is disposed closer to the fourth side.

14. The substrate of claim 10, wherein grounds of the plurality of duplexers are independently disposed.

15. The substrate of claim 10, wherein grounds on a reception side of the plurality of duplexers are disposed in common.
